# EUROPEAN PATENT APPLICATION

(11) **EP 4 707 831 A1**
(43) Date of publication of application: **11.03.2026**
(21) Application number: 24199581.0
(22) Date of filing: 10.09.2024
(51) Int. Cl.: G01R 31/392, G01R 31/396

(54) **A METHOD OF MONITORING BATTERY BLOCKS OF A BATTERY**

(71) Applicant: Novum engineerING GmbH, 01067 Dresden (DE)
(72) Inventor: BIRTH, Sören, 01307 Dresden (DE); SCHMEIDA, Toni, 01187 Dresden (DE)
(74) Representative: Ter Meer Steinmeister & Partner

(57) **Abstract**

A system and a method of monitoring the behavior of battery blocks (b1,...,bn) connected in series. For each of a plurality of points in time (t₀,t ₋₁,t ₋₂), and for each battery block, a deviation value (ΔU_{b1},...,ΔU_{bn}) is calculated, being a voltage deviation of the voltage measurement from an average (M) of the voltage measurements (U_{b1},...,U_{bn}) of the battery blocks, or is a corresponding charge deviation. A mapping (10) of voltage values (U₁,...,U_{z}) or current values to deviation values (ΔU₁,...,ΔU_{z}) is determined. To each voltage or current value is assigned an extreme value of those deviation values of the battery block that have been calculated for points in time at which a voltage or current measurement has been measured that corresponds to the voltage or current value. The mapping (10) is evaluated to detect a potentially anomalous state of the battery block.

## Description

The invention relates to monitoring the behavior of a plurality of battery blocks that are connected in series in a battery, for detecting an anomalous state of one of the plurality of battery blocks.

### Summary of the invention

Batteries, in particular electrochemical batteries such as lithium ion batteries, are increasingly used for battery storages. It is desirable to provide for an economical, safe and sustainable operation of a battery storage.

It is an object of the present invention to provide a novel method of monitoring the behavior of a plurality of battery blocks that are connected in series in a battery.

It is desirable that the method allows for monitoring the behavior of the battery blocks on the basis of only electrical parameters that are readily available in a battery management system of a battery storage.

It is desirable that the method allows for establishing the monitoring of the behavior of the battery blocks in an unobstrusive manner.

In particular, it is desirable that the method allows for monitoring the behavior of the battery blocks on the basis of only voltage measurements or only voltage and current measurements, taken at respective points in time.

It is furthermore desirable to be able to automatically detect an anomalous state of one of the plurality of battery blocks, in particular a potentially safety-relevant state and/or a state reflecting a manufacturing defect.

It is furthermore desirable that the method may detect an anomalous state of a battery block without having to rely on an ideal or perfectly normal battery as a reference.

The invention is indicated in the independent claims. Further embodiments are indicated in the dependent claims.

According to one aspect of the invention, there is provided a method of monitoring the behavior of a plurality of battery blocks that are connected in series in a battery, for detecting a potentially anomalous state of one of the plurality of battery blocks. The method comprises: for each point in time of a plurality of points in time, providing a voltage measurement of each of the plurality of battery blocks measured at the point in time. The method further comprises: for each point in time of the plurality of points in time, and for each battery block of the plurality of battery blocks, calculating a deviation value of the battery block. The deviation value is a voltage deviation of the voltage measurement of the battery block from an average of the voltage measurements of the plurality of battery blocks (at that point in time), or is a charge deviation of the battery block that corresponds to the voltage deviation. The method further comprises: for each battery block of the plurality of battery blocks and for a first time frame, determining a mapping of voltage values or current values to deviation values, wherein to each voltage value of the voltage values or to each current value of the current values, there is assigned an extreme value of those deviation values of the battery block that have been calculated for respective points in time at which a voltage measurement or a current measurement of the battery block has been measured that corresponds to the voltage value or, respectively, to the current value. Said respective points in time belong to the first time frame. That is, determining the mapping comprises assigning respective extreme values to respective voltage values or current values. The mapping of voltage values or current values to deviation values is a mapping of voltage values or current values to deviation values in the form of said extreme values. The method further comprises: for each battery block of the plurality of battery blocks, evaluating the determined mapping to detect a potentially anomalous state of the battery block.

The battery may also be termed "the monitored battery". During usage of the battery, the battery blocks connected in series typically undergo the same succession of charging, energy storing, discharging, and so on. Moreover, the battery blocks typically are of a similar structure and similar age, having similar electrical parameters such as the capacity. When calculating the deviation value of a battery block, the average of the voltage measurements of the battery blocks is used as a reference that is "self-generated" on a local basis. The voltage measurements stem from the battery blocks that are subject to a same current, at a point in time, because the battery blocks are connected in series. The difference between a voltage measurement of an individual battery block and the average of the voltage measurements of the battery blocks may not show any significant characteristics, when taken alone. However, by determining the mapping, the deviation values are distinguished according to the voltage measurement value (or current measurement value) at which the deviation value occurred. This is advantageous, since the deviation of the behavior of a specific battery block from the average of the battery blocks may be dependent on the voltage. Moreover, for a voltage value, only the extreme value of the respective deviation values is selected for the mapping. Thereby, the evaluation is based on the highly selective mapping which furthermore emphasizes the extreme values. Thus, based on the voltage measurements, and using the average of the voltage measurements of the battery blocks as a "self-generated" reference, a potentially anomalous state of one of the battery blocks connected in series may be detected.

Because the mapping/assigning selects the calculated deviation value which is the extreme value, relevant anomalous deviation values are emphasized over "normal" deviation values that may occur as well. This improves the evaluating to detect a potentially anomalous state. Moreover, as the plurality of deviation values allow for distinguishing the voltage (or current) at which the deviation values (for example, voltage differences) occur, it is possible to specifically evaluate the behavior of a battery block at one or more specific voltage ranges (or current ranges). Thus, anomalous behavior at one or more specific voltage ranges (or current ranges) of the battery block may be detected, even if the behavior at other voltage ranges or current ranges appears to be "normal". For example, a deviation of the deviation values may be evaluated that is specific to a predetermined upper/lower voltage partial range of a voltage range including the plurality of the voltage measurements. Thus, anomalous behavior at relatively high/low charging states of the battery block may be detected, even if the behavior at middle charging states appears to be "normal". In the following, wherever an evaluation/detection of a deviation in a partial range is described, this may comprise an evaluation/detection of the deviation, wherein the deviation is specific to that partial range.

For example, the extreme value of those deviation values may be the calculated deviation value with the greatest absolute value. Alternatively, the extreme value may comprise the smallest value and the greatest value of those deviation values.

The term "battery block" is understood as being a unit in a battery or battery storage, for which unit voltage measurements are available. The battery block may include one or more battery cells. In particular, the battery block may include multiple battery cells connected in parallel. The term "battery block" may include a single battery cell.

The battery may include a battery module or a battery string, in which the said plurality of battery blocks are connected in series. The battery may be a part of a battery storage. The battery storage may comprise a battery management system.

The term "voltage measurement" is understood to mean a value obtained by measuring the voltage. The providing of the voltage measurement may include measuring the voltage to obtain the voltage measurement. For example, the voltage measurement may be provided by the battery management system. The voltage measurement is measured at the respective point in time. For example, the voltage measurement may be taken at the point in time or may have occurred at the point in time.

The calculated deviation value is associated with the point in time of the corresponding voltage measurement. It may be said that the deviation value "occurred" at the point in time, "occurred" at the voltage measurement, and/or "occurred" at a corresponding current measurement that has been measured at the same point in time.

The calculated deviation value is a signed deviation value, that is, the sign of the voltage deviation from the average of the voltage measurements is preserved. If applicable, the sign of the charge deviation corresponds to the sign of the voltage deviation.

The charge deviation may be an estimated charge deviation. The charge deviation may be estimated based on the voltage deviation. The charge deviation may be calculated according to voltage-charge characteristics of the battery block or the plurality of battery blocks, and based on the voltage measurement of the battery block. The voltage-charge characteristics may define a relation between voltage and charge at different voltages. The voltage-charge characteristics of the battery blocks may be an ideal or estimated voltage-charge characteristics. The voltage-charge characteristics of the battery block may be a voltage-charge curve, in particular a voltage-SoC-curve describing a relation of voltage and state of charge (SoC). For example, at a specific voltage (voltage measurement), the slope or the local behavior of the voltage-charge curve describes a relation between the voltage deviation and a corresponding charge deviation at said specific voltage.

The method may include, for each point in time of said plurality of points in time, providing the current measurement of the plurality of battery blocks.

The first time frame may have a predetermined length or duration. The length of the first time frame may be at least 14 days, preferably at least 20 days, more preferably at least 28 days. Thereby, typically, voltage measurements at many different states of charge of the battery may be included with the voltage measurements. The length of the first time frame may be less than 2 months, preferably less than 1 month. Thereby, development of an anomalous state of a battery block may be detected on a suitable time scale.

The number of the points in time that belong to the first time frame may be at least 100.000, preferably at least 400.000.

The plurality of points in time may succeed one another at a temporal distance of, for example, one second or more. The temporal distance may be at least one second, or at least 5 seconds. The temporal distance may be 1 hour or less, 10 minutes or less, 5 minutes or less, or, preferably 60 seconds or less.

The voltage values or current values of the mapping may comprise at least 20 different values, preferably at least 50 different values. The voltage measurements and/or the voltage values may extend over a voltage range having a width of at least 0,5 V. The current measurements and/or the current values may extend over a current range having a width of at least 0.2C, preferably at least 1C. Herein, 0.2C or 1C denote the C-rate.

In embodiments, said average of the voltage measurements of the plurality of battery blocks is the median of the voltage measurements of the plurality of battery blocks.

However, the average may also be the arithmetic mean or other central tendency of the voltage measurements of the battery blocks measured at said respective point in time.

In embodiments, said evaluating comprises evaluating the determined mapping with respect to at least one reference deviation value, wherein the at least one reference deviation value is at least one predetermined reference deviation value, or wherein the at least one reference deviation value is obtained based on the mappings for the other blocks of the plurality of battery blocks, or wherein the at least one reference deviation value is obtained based on corresponding mappings of a corresponding battery block of corresponding batteries.

In embodiments, said evaluating comprises evaluating the determined mapping with respect to at least one reference mapping, wherein the at least one reference mapping is a predetermined reference mapping, or wherein the at least one reference mapping comprises the mappings for the other blocks of the plurality of battery blocks, or wherein the at least one reference mapping is obtained based on corresponding mappings of a corresponding battery block of corresponding batteries.

Corresponding batteries may be batteries that are structurally identical with the monitored battery, or batteries of a similar type as the monitored battery. The corresponding batteries include batteries other than the (monitored) battery of which the voltage measurements are provided.

Corresponding mappings of a corresponding battery block of corresponding batteries are obtained in the same manner as the mapping that is determined for the respective block of the plurality of battery blocks of the monitored battery. That is, the corresponding mappings may be determined in a manner that corresponds to the steps of calculating a deviation values and determining the mapping for the corresponding battery block of the monitored battery. Likewise, deviation values of battery blocks of corresponding batteries are obtained in the same manner as the deviation values of the respective block of the plurality of battery blocks of the monitored battery. Deviation values of battery blocks of corresponding batteries may also be called corresponding derivation values.

Thus, the reference deviation value or the reference mapping may be obtained based on corresponding measurements of a plurality of batteries of a similar kind ("corresponding batteries"), in particular batteries that structurally identical with the monitored battery. This is particularly advantageous in that, for example, the behavior of a specific battery block, say battery block #n of the battery blocks connected in series, may be evaluated with respect to the behavior of battery block #n of a plurality of structurally identical batteries in the field. Whereas a battery block #n might have a specific behavior, this specific behavior might be due to constructional differences between the battery blocks connected in series and might appear in a similar manner in the plurality of structurally identical batteries. However, when the behavior of battery block #n is different from the behavior of battery block #n of a plurality of structurally identical batteries, an anomalous state may be detected. Thus, detection of a potentially anomalous state of a respective one of the battery blocks is considerably improved. For example, a reference mapping may be an average of reference mappings of a plurality of corresponding batteries. That is, obtaining an average of reference mappings is understood as comprising calculating the average (for example, the arithmetic mean) of deviation values, for each of corresponding voltage values or current values of the mappings. Obtaining the average of reference mappings may include interpolating the reference mappings over the voltage values or current values.

In particular, for example, when a deviation of the behavior of a specific battery block from the behavior of the corresponding battery block of the plurality of the corresponding batteries is determined to increase over monitoring time, a potentially safety-relevant state of the battery block may be detected. An increase over monitoring time may be determined, for example, by repeating the steps of determining a mapping and evaluating the determined mapping for at least one second time frame, for example, for a plurality of new second time frames, each second time frame progressing in time with respect to the preceding time frame; detecting the deviation for each of the time frames; and determining an increase of the deviation based on linear regression of the detected deviations, for example. An increase of the deviation may also be determined by other algorithms.

The second time frame may be an updated time frame. For example, a new second time frame may be processed every day. Each second time frame may overlap with the previous, or first, time frame by a time overlap. Each first and second time frame may have a same length or duration.

Herein, an increasing or decreasing over monitoring time may comprise an increasing or decreasing in time in a direction towards the (end of the) first time frame, in particular, from at least one second time frame towards the (end of the) first time frame. For example, the monitoring time may extend over a longer time than the length of the respective time frame. For example, the steps of determining a mapping and evaluating the determined mapping may be repeated for new/updated time frames, for example, on a daily basis, or after a number of days, which number is preferably at least 1 and/or preferably less than 8. Each new time frame may overlap with a previous time frame. For example, each new time frame may overlap with a previous time frame by at least one day, or said number of days.

Further below, embodiments are described in which it is determined whether a deviation increases over monitoring time. Furthermore, embodiments are described in which it is determined whether an extent of a deviation increases over monitoring time. This may be determined in a similar manner.

The at least one reference deviation value may be a (statistical) representation of deviation values of corresponding batteries. Likewise, the at least one reference mapping may be a (statistical) representation of corresponding mappings.

The method may include: gathering, from corresponding batteries, a respective at least one corresponding deviation value that is specific to a corresponding battery block of a corresponding battery. The method may include determining the at least one reference deviation value based on at least one corresponding deviation value specific to a corresponding battery block of corresponding batteries. The method may include determining the at least one reference mapping based on at least one corresponding deviation value specific to a corresponding battery block of corresponding batteries.

In embodiments, the potentially anomalous state of the battery block is a potentially safety-relevant state and/or a state reflecting a manufacturing defect.

The method may comprise detecting a potentially safety-relevant state and detecting a state reflecting a manufacturing defect. In particular, a safety-relevant state may be detected independently from detecting a state reflecting a manufacturing defect. In particular, when a deviation from an expected behavior or from at least one reference mapping is detected to increase over monitoring time, this may be detected as a potentially safety-relevant state.

In an embodiment, the mapping is a mapping of voltage values to deviation values, wherein the steps of determining a mapping and evaluating the determined mapping are repeated for at least one second time frame, wherein said evaluating comprises: detecting, in a predetermined upper voltage partial range of a voltage range that includes the voltage measurements of the battery block, a negative deviation of the deviation values with respect to a first reference deviation value. The method may include: determining whether the negative deviation increases over (monitoring) time. That is, it is determined whether the absolute value of the negative deviation increases over monitoring time.

In particular, the negative deviation may be specific to the predetermined upper voltage partial range, and/or may be detected only in the predetermined upper voltage partial range.

Such an increasing negative deviation in an upper voltage range may be caused by charging energy being used in undesired side reactions, which may lead to undesired lithium plating taking place in the respective battery block. When lithium dendrites or flat lithium structures build up in a battery cell, this might result in an internal short circuit, causing a strong exothermic reaction. Due to the detection of the negative deviation in the upper voltage range, a timely recognition of the anomalous state is made possible, which may serve to avoid severe damages.

The method may include: when it is determined that the negative deviation increases over (monitoring) time, detecting a potentially anomalous state of the battery block that is a potentially safety-relevant state.

The first reference deviation value may be a predetermined first reference deviation value. The first reference deviation value may also be a reference deviation value that is determined based on the mappings for the other blocks of the plurality of battery blocks.

In an embodiment, the mapping is a mapping of voltage values to deviation values. Said evaluating may comprise: detecting, in a predetermined upper voltage partial range of a voltage range that includes the voltage measurements of the battery block, a positive deviation of the deviation values with respect to a predetermined second reference deviation value, the positive deviation overall increasing with increasing voltage values; and/or detecting, in a predetermined lower voltage partial range of the voltage range that includes the voltage measurements of the battery block, a negative deviation of the deviation values with respect to a predetermined third reference deviation value, the negative deviation overall increasing with decreasing voltage values.

In particular, the positive deviation may be specific to the predetermined upper voltage partial range, and/or may be detected only in the predetermined upper voltage partial range. Likewise, the negative deviation may be specific to the predetermined lower voltage partial range, and/or may be detected only in the predetermined lower voltage partial range.

Such combination of positive and negative deviations indicates that the specific battery block appears to have a lower capacity than the other battery blocks. Such combination of positive and negative deviations may be due to a battery block having a poor welding quality. Thus, it is made possible to detect a construction error such as a poor welding quality, which otherwise would hardly be detectable during usage of the battery. In particular, there may be no deviation detectable in a middle voltage partial range. Thus, due to the separate evaluation of upper and lower voltage partial ranges, which are outside a middle voltage partial range, and due to the selecting and assigning of the extreme values, it is made possible to detect the anomalous state.

The method may include: when the positive deviation and the negative deviation are detected, detecting a potentially anomalous state of the battery block.

Whether the positive deviation overall increases with increasing voltage values, and/or whether the negative deviation overall increases with decreasing voltage values may be determined, for example, by linear regression.

In an embodiment, the mapping is a mapping of voltage values to deviation values, wherein the method includes: evaluating the determined mappings of each battery block of the plurality of battery blocks to determine whether at least one first mapping and at least one second mapping of the mappings show respective deviations from zero deviation, the deviations of the at least one first mapping being overall symmetric to the deviations of the at least one second mapping of the mappings with respect to a sign of the deviation values. The method may include: if this is the case, detecting a potentially anomalous state of the corresponding battery blocks. This may indicate an asynchronous behavior of the battery blocks or battery cells.

In an embodiment, the mapping is a mapping of voltage values to deviation values, wherein said evaluating comprises: detecting, in a predetermined upper voltage partial range of a voltage range that includes the voltage measurements of the battery block, a negative deviation of the deviation values with respect to a predetermined fourth reference deviation value the negative deviation overall increasing with increasing voltage values; and/or detecting, in a predetermined lower voltage partial range of the voltage range that includes the voltage measurements of the battery block, a positive deviation of the deviation values with respect to a predetermined fifth reference deviation value, the positive deviation overall increasing with decreasing voltage values.

In particular, the negative deviation may be specific to the predetermined upper voltage partial range, and/or may be detected only in the predetermined upper voltage partial range.

Likewise, the positive deviation may be specific to the predetermined lower voltage partial range, and/or may be detected only in the predetermined lower voltage partial range.

The method may include: when the negative deviation and the positive deviation are detected, detecting a potentially anomalous state of the battery block.

In an embodiment, the mapping is a mapping of voltage values to deviation values, wherein the steps of determining a mapping and evaluating the determined mapping are repeated for at least one second time frame. Said evaluating may comprise: detecting, in a predetermined lower voltage partial range of a voltage range that includes the voltage measurements of the battery block, a negative deviation of the deviation values with respect to a seventh reference deviation value. The method may include: determining whether the negative deviation increases over (monitoring) time.

The method may include: when it is determined that the negative deviation increases over (monitoring) time, detecting a potentially anomalous state of the battery block that is a potentially safety-relevant state.

The method may further comprise: determining a speed of the increase of the negative deviation. The method may include: when it is determined that the speed of the increase exceeds a reference value, detecting a potentially anomalous state of the battery block that is a potentially safety-relevant state.

Such an increasing negative deviation may be due to lithium plating reactions in a battery cell. Thus, even when a battery does not (or not often) reach a predetermined higher voltage partial range during normal operation of the battery, detection of lithium plating related anomalous states is made possible.

Said evaluating may comprise: evaluating the mapping for the first time frame and the mapping for the at least one second time frame by a machine learning algorithm that is trained for detecting a potentially anomalous state of the battery block that is a potentially safety-relevant state. The machine learning algorithm may be configured to detecting the potentially anomalous state of the battery block based on the negative deviation increasing over time and/or a speed of the increase of the negative deviation. For example, a part of the respective mapping that corresponds to the predetermined lower voltage partial range of a voltage range may be input into the machine learning algorithm.

In an embodiment, the mapping is a mapping of voltage values to deviation values, wherein the method comprises: scaling and/or adjusting the determined mapping based on a reference mapping, before the step of evaluating the mapping, wherein the reference mapping is obtained based on corresponding mappings of a corresponding battery block of corresponding batteries. Said evaluating may comprise: detecting, in a predetermined lower voltage partial range of the voltage range that includes the voltage measurements of the battery block, a positive deviation of the deviation values with respect to a predetermined sixth reference deviation value, the positive deviation overall increasing with decreasing voltage values.

The method may include: when positive deviation is detected, detecting a potentially anomalous state of the battery block that is a potentially safety-relevant state.

Such an increasing positive deviation in a lower voltage range may indicate a growing excess voltage of a battery block. This may be caused by undesired, partly reversible lithium plating taking place in the respective battery block.

In an embodiment, the mapping is a mapping of current values to deviation values, wherein said evaluating comprises: determining a zero current deviation value that corresponds to the value of a linear function at a current value of zero, the linear function having a best fit to the mapping. Said evaluating may comprise: when the absolute value of the zero current deviation value exceeds a threshold value, a potentially anomalous state of the battery block is detected that is a potentially safety-relevant state.

The zero current deviation value indicates a magnitude of self-discharge of the battery block. In particular, when the absolute value of the zero current deviation value exceeds a threshold value, there is a high probability that the battery block has a high-impedance internal short circuit, which is potentially dangerous. Preferably, the threshold value is less than 20 mV. The threshold value may be 10 mV, for example.

For example, a linear function may be fitted to the mapping, and the value of the linear function at a current value of zero may be determined.

The method may include: determining a slope of the linear function having a best fit to the mapping, wherein when the absolute value of the slope exceeds a threshold value, a potentially anomalous state of the battery block is detected. The slope corresponds to the relative ohmic impedance of the respective battery block.

One or more of the herein described evaluations may be combined, that is, the evaluations may be done in parallel.

In any of the above described embodiments, the method may include one or more of the following features:
The method may be a computer-implemented method.

The first, second, third, fourth, fifth, sixth and/or seventh reference deviation values may be respective first, second, third, fourth, fifth, sixth and/or seventh threshold values.

The steps of determining a mapping and evaluating the determined mapping may be repeated for at least one second time frame, as described above.

The method may include: determining whether an extent of the deviations increases over (monitoring) time. The method may include: determining whether an extent of the deviations overall remains the same over (monitoring) time.

The method may include: when it is determined that the extent of the deviations increases over (monitoring) time, detecting a potentially anomalous state of the battery block that is a potentially safety-relevant state. The method may include: when it is determined that the extent of the deviations overall remains the same over (monitoring) time, detecting a potentially anomalous state of the battery block that is a state reflecting a manufacturing defect.

The method may include: determining whether an extent of the positive deviation and/or an extent of the negative deviation increases over (monitoring) time. The method may include: determining whether an extent of the positive deviation and/or an extent of the negative deviation overall remains the same over (monitoring) time.

The method may include: when it is determined that an extent of the positive deviation and/or an extent of the negative deviation increases over (monitoring) time, detecting a potentially anomalous state of the battery block that is a potentially safety-relevant state. In particular, this may allow to detect a case of a battery block that undergoes a rapid aging process, which might lead to thermal runaway.

The method may include: when it is determined that an extent of the positive deviation and/or an extent of the negative deviation overall remains the same over (monitoring) time, detecting a potentially anomalous state of the battery block that is a state reflecting a manufacturing defect.

In an aspect of the invention, there is provided a battery monitoring system, the system comprising means for carrying out the steps of the method as described herein. In at least one embodiment, the system comprises computational means for receiving and processing the voltage measurements or the voltage measurements and current measurements. The system may comprise means for receiving and/or calculating the reference deviation values. The system may comprise means for receiving and/or calculating the reference mappings.

Preferred embodiments of the invention will now be described in conjunction with the drawings, in which:
Fig. 1 is a schematic illustration of a method of and system for monitoring the behavior of a plurality of battery blocks that are connected in series in a battery;
Fig. 2 a) to d) are diagrams showing mappings of voltage values to deviation values for a plurality of battery blocks that are connected in series in a battery;
Fig. 3 a) to d) are diagrams showing a sequence over monitoring time of mappings of voltage values to deviation values for a plurality of battery blocks that are connected in series in a battery;
Fig. 4 is a schematic illustration of steps of a method of monitoring the behavior of a plurality of battery blocks that are connected in series in a battery;
Fig. 5 is a schematic illustration of a method of monitoring the behavior of a plurality of battery blocks that are connected in series in a battery; and
Fig. 6 a) and b) are diagrams showing mappings of voltage values to deviation values for a plurality of battery blocks that are connected in series in a battery.

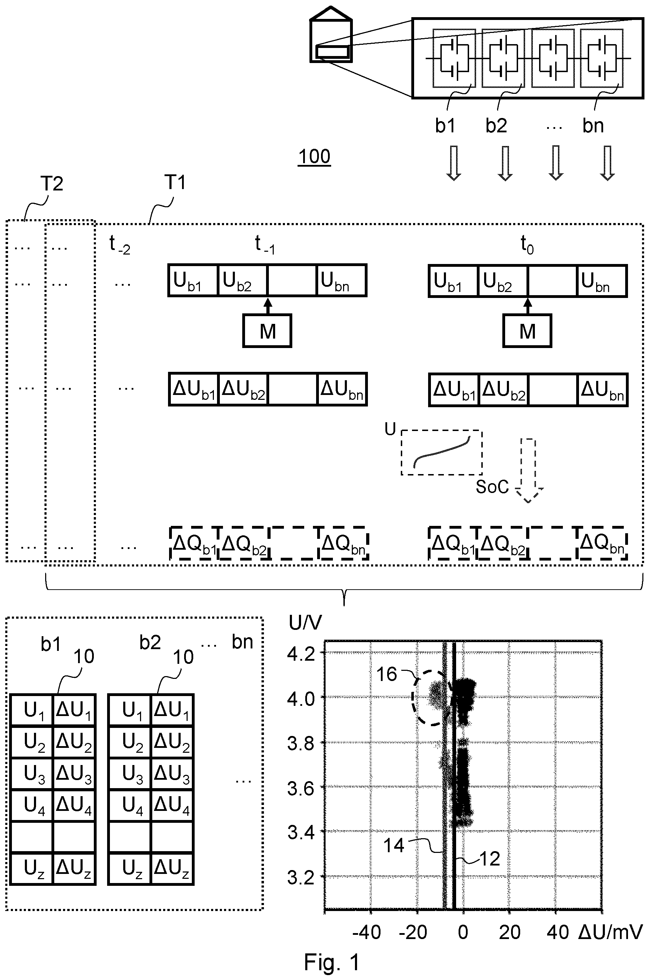

Fig. 1 schematically shows a method of and system 100 for monitoring the behavior of a plurality of battery blocks b1, ..., bn that are connected in series in a battery, for detecting a potentially anomalous state of one of the plurality of battery blocks b1, ..., bn. The battery may be a part of a battery storage.

For each point in time of a plurality of points in time t₀, t ₋₁, t ₋₂, ..., there is provided a voltage measurement U_{b1}, ..., U_{bn} of each of the plurality of battery blocks b1, ..., bn measured at the point in time. For example, the measurements may be taken every 5 minutes over a first time frame T1 of, for example, 28 days.

For the first time frame T1, the following operations are performed:
For each point in time of the plurality of points in time t₀, t ₋₁, t ₋₂, ... that belong to the first time frame T1, and for each battery block of the plurality of battery blocks b1, ..., bn, an average M in form of the median of the voltage measurements U_{b1}, ..., U_{bn} of the plurality of battery blocks b1, ..., bn, is calculated. Furthermore, a deviation value ΔU_{b1}, ..., ΔU_{bn} of the battery block is calculated. The deviation value ΔU_{b1}, ..., ΔU_{bn} is a voltage deviation of the voltage measurement U_{b1}, ..., U_{bn} of the battery block from the average M of the voltage measurements U_{b1}, ..., U_{bn} of the plurality of battery blocks b1, ..., bn for the respective point in time.

For each battery block of the plurality of battery blocks b1, ..., bn and for the first time frame T1, a mapping 10 of voltage values U₁, ..., U_{z} to deviation values ΔU₁, ..., ΔU_{z} is determined. In particular, for each voltage value of the voltage values U₁, ..., U_{z}, the deviation values of the battery block that have occurred at the voltage value are evaluated, and an extreme value of these deviation values is assigned to the voltage value (that is, the voltage value is mapped to the respective extreme value). The extreme value is the deviation value having the largest absolute value among these deviation values.

For example, ΔUb₁ has been calculated for (has occurred for) Ubi; if Ub₁ has a voltage value equal to ΔU₃ = 4.0 V, for example, and if ΔUb₁ is the largest deviation value ΔUb₁ of the plurality of points in time t₀, t ₋₁, t ₋₂, ... that belong to the first time frame T1 and that have occurred at the voltage value ΔU₃, ΔUb₁ will be assigned to the voltage value ΔU₃.

In other words, for the battery block, to each voltage value of the voltage values U₁, ..., U_{z}, there is assigned the extreme value of those deviation values of the battery block that have been calculated for respective points in time at which a voltage measurement or a current measurement of the battery block has been measured that corresponds to the voltage value, said respective points in time belonging to the first time frame T1.

In the lower right part of Fig. 1, there is shown a diagram of the mapping 10 for the plurality of battery blocks b1, ..., bn.

For each battery block of the plurality of battery blocks b1, ..., bn, the determined mapping 10 is evaluated to detect a potentially anomalous state of the battery block. The determined mapping 10 is evaluated with respect to at least one reference deviation value 12; 14 (shown as vertical lines in the diagram). Specifically, as shown in the diagram of Fig. 1, a negative deviation 16 of the deviation values with respect to a first reference deviation value 14 is detected in a predetermined upper voltage partial range of a voltage range that includes the voltage measurements U_{b1}, ..., U_{bn} and the voltage values U₁, ..., U_{z}.

The steps of determining a mapping 10 and evaluating the determined mapping 10 are repeated for a plurality of second time frames T2, and it is determined whether the observed negative deviation 16 increases over monitoring time (that is, the observed negative deviation 16 overall increases over the overlapping time frames T1, T2, ...). If that is the case, a potentially anomalous state of the battery block that is a potentially safety-relevant state is detected; the battery block might be affected by undesired lithium plating.

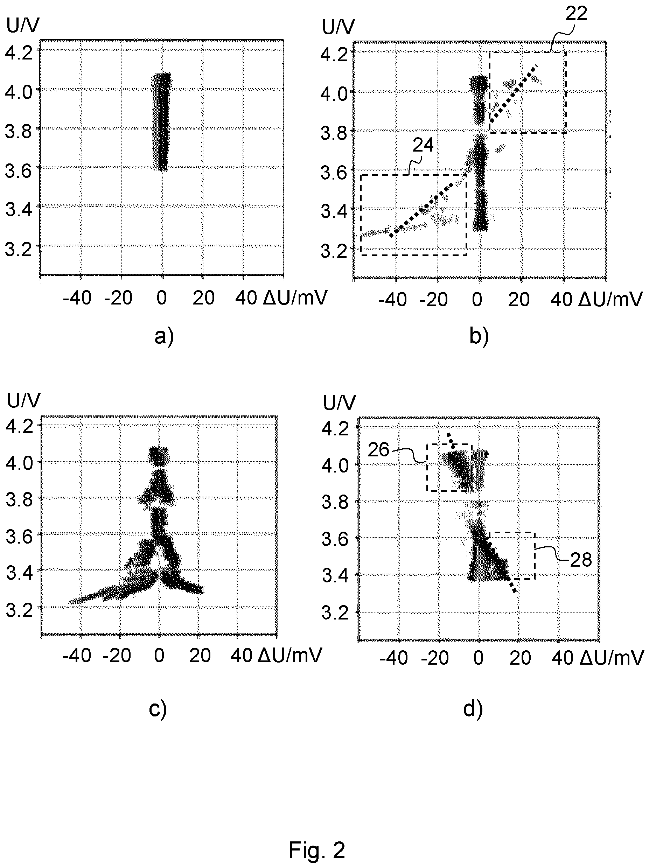

For comparison, Fig. 2a) shows a diagram of mappings of voltage values to deviation values of a case where no negative deviations 16 are observed in the shown voltage range.

Fig. 2b) shows a similar diagram of mappings of voltage values to deviation values. In this case, in a predetermined upper voltage partial range of the voltage range that includes the voltage measurements of the battery block, a positive deviation 22 (inside the upper box) of the deviation values is detected with respect to a predetermined second reference deviation value (corresponding to the left border of the upper box). As schematically indicated by a dotted line, the positive deviation 22 overall increases with increasing voltage values. Furthermore, in a predetermined lower voltage partial range of the voltage range, a negative deviation 24 (inside the lower box) of the deviation values is detected with respect to a predetermined third reference deviation value (corresponding to the right border of the lower box). As schematically indicated by a dotted line, the negative deviation 24 overall increases with decreasing voltage values.

Fig. 2c) shows another similar diagram of mappings of voltage values to deviation values. In this case, the determined mappings of each battery block of the plurality of battery blocks b1, ..., bn are evaluated to determine whether at least one first mapping and at least one second mapping of the mappings show respective deviations from zero deviation (for example, respectively exceed reference deviation values in the form of positive and negative threshold deviation values. The diagram shows a case in which the deviations of the at least one first mapping are overall symmetric to the deviations of the at least one second mapping with respect to a sign of the deviation values (that is, they are mirror symmetric with respect to a value of ΔU = 0 mV). in this case, a potentially anomalous state of the corresponding battery blocks is detected. Thereby, an asynchronous behavior of the battery blocks or battery cells may be detected.

Fig. 2d) shows another similar diagram of mappings of voltage values to deviation values. In this case, in a predetermined upper voltage partial range of a voltage range that includes the voltage measurements of the battery block, a negative deviation 26 of the deviation values is detected with respect to a predetermined fourth reference deviation value (corresponding to the right border of the upper box). As schematically indicated by a dotted line, the negative deviation overall increases with increasing voltage values. Furthermore, in a predetermined lower voltage partial range of the voltage range, a positive deviation 28 of the deviation values is detected with respect to a predetermined fifth reference deviation value (corresponding to the left border of the lower box). As schematically indicated by a dotted line, the positive deviation overall increases with decreasing voltage values.

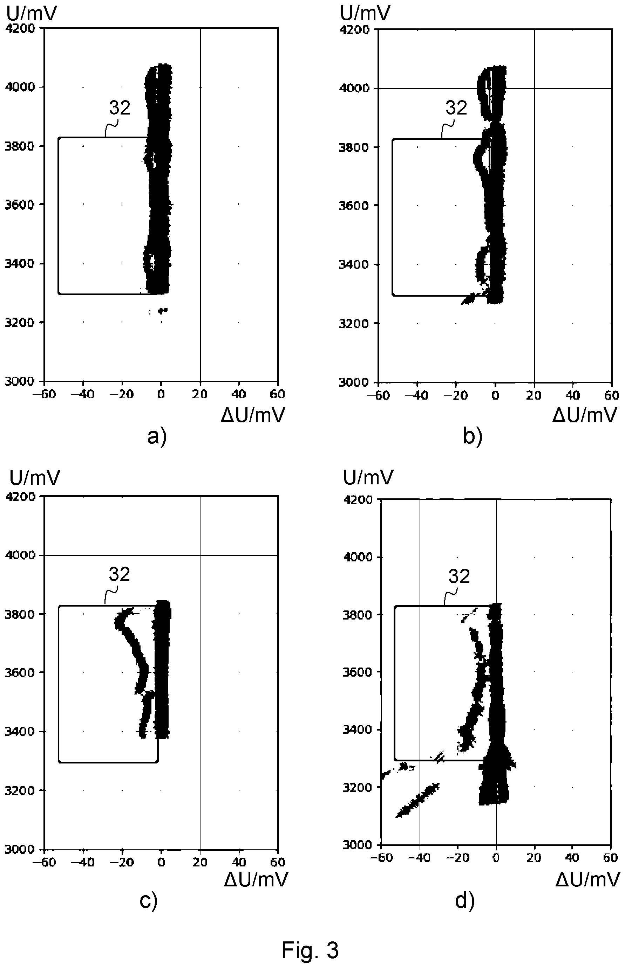

Fig. 3a) to 3d) show a sequence of similar diagrams of mappings of voltage values to deviation values. The steps of determining a mapping 10 and evaluating the determined mapping 10 are repeated for a plurality of second time frames T2, and in a predetermined lower voltage partial range of a voltage range that includes the voltage measurements of the battery block, a negative deviation 32 of the deviation values is it is detected with respect to a seventh reference deviation value (corresponding to the right border of the inner box). For the sequence, it is determined whether the negative deviation overall increases over monitoring time (that is, the observed negative deviation 32 overall increases over the overlapping time frames T1, T2, ...).

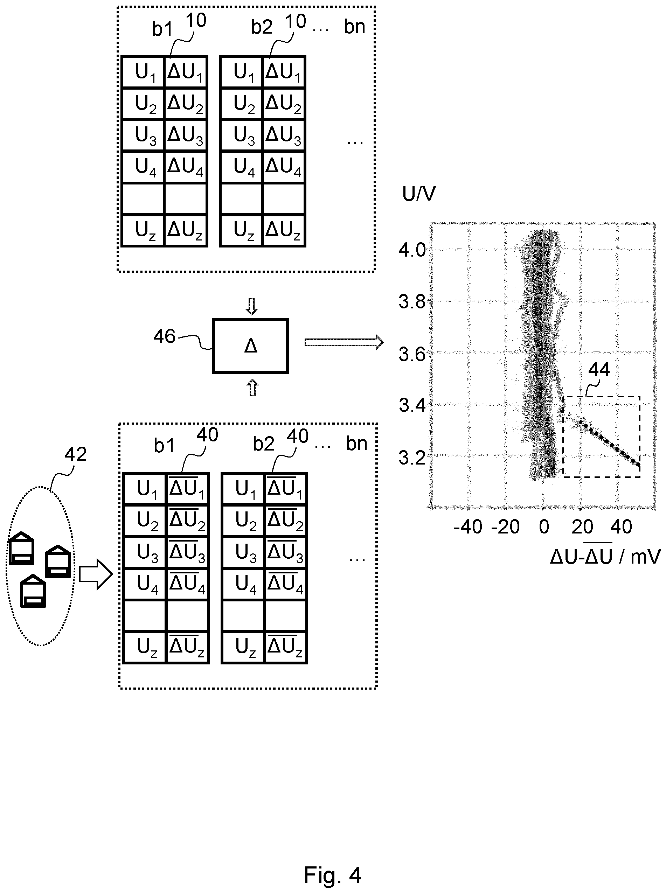

Fig. 4 schematically illustrates steps of another method of monitoring the behavior of a plurality of battery blocks b1, ..., bn that are connected in series in a battery. The steps up to the step of determining the mappings 10 are similar to the method of Fig. 1, and a description thereof is therefore not repeated here. In a step 46, each determined mapping 10 is scaled based on a reference mapping 40, before the step of evaluating the mapping 10. The reference mapping 40 is obtained based on corresponding mappings of a respective corresponding battery block of corresponding batteries 42. In particular, the reference mapping is obtained by calculating the average of the corresponding deviation values ΔU_{b1}, ..., ΔU_{bn} for a corresponding battery block of the corresponding batteries 42. Evaluating the scaled mapping 10 includes: detecting, in a predetermined lower voltage partial range of the voltage range that includes the voltage measurements of the battery block, a positive deviation 44 of the deviation values with respect to a predetermined sixth reference deviation value. As schematically indicated by a dotted line, the positive deviation overall increases with decreasing voltage values. Thus, a growing excess voltage of a battery block may be detected, which may be caused by undesired, partly reversible lithium plating.

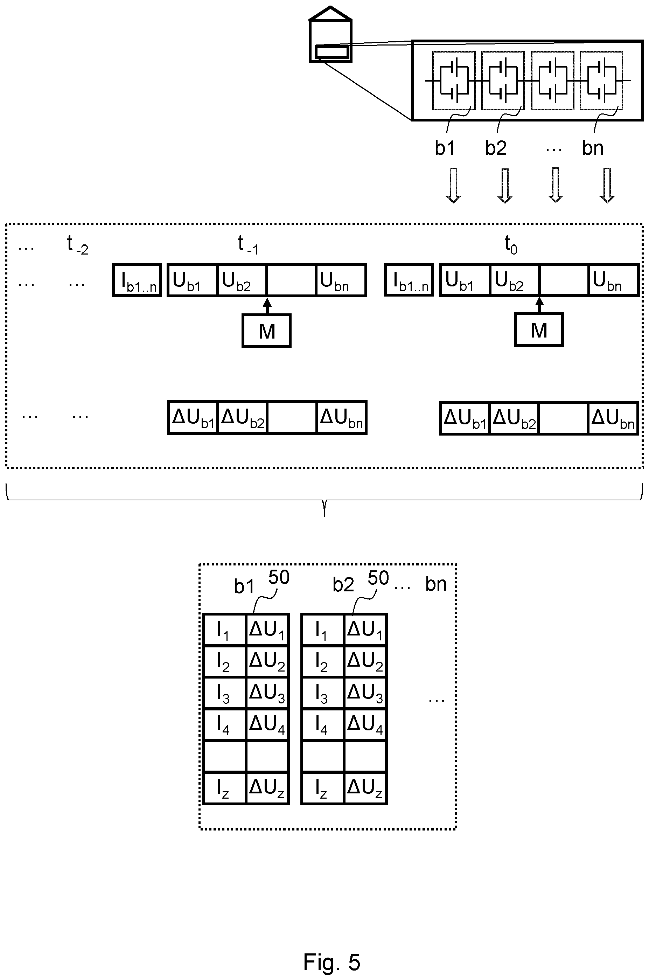

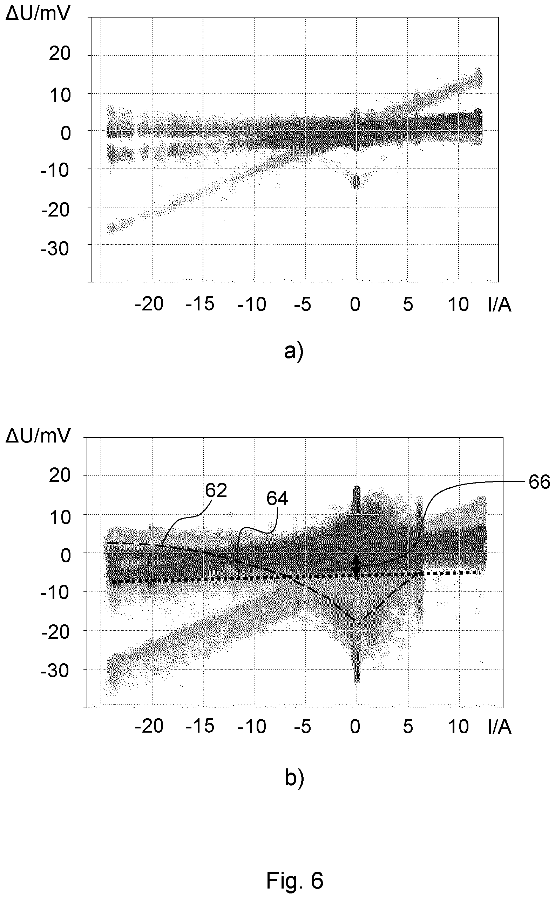

Fig. 5 and Fig. 6 schematically illustrate steps of another method of monitoring the behavior of a plurality of battery blocks b1, ..., bn that are connected in series in a battery. The method is similar to the method of Fig. 1; differences are described in the following. A main difference is that the mapping 50 is a mapping of current values I₁, ..., I_{z} to deviation values ΔU₁, ..., ΔU_{z}.

For each battery block of the plurality of battery blocks b1, ..., bn and for the first time frame T1, a mapping 50 of current values I₁, ..., I_{z} to deviation values ΔU₁, ..., ΔU_{z} is determined. In particular, for each current value of the current values I₁, ..., I_{z}, the deviation values of the battery block that have occurred at the current value (measured for the battery blocks connected in series) are evaluated, and an extreme value of these deviation values is assigned to the current value (that is, the current value is mapped to the respective extreme value). The extreme value is the deviation value having the largest absolute value among these deviation values.

Fig. 6a) shows mappings 50 for the plurality of battery blocks b1, ..., bn in a normal state. Each mapping corresponds to a linear function, the slope of which indicates the ohmic resistance of the battery block.

Fig. 6b) shows mappings 50 for the plurality of battery blocks b1, ..., bn in a case where a potentially safety-relevant state is detected as follows. For illustration purposes, the mapping 50 of one of the battery blocks is indicated by a dashed line 62 that has a (negative) minimum at zero current. A linear function 64 having a best fit to the mapping 50 is determined. The linear function 64 is schematically illustrated in Fig. 6b). A zero current deviation value 66 is determined that corresponds to the value of the linear function 64 at a current value of zero. When the absolute value of the zero current deviation value 66 of a battery block exceeds a threshold value, a potentially anomalous state of the battery block is detected that is a potentially safety-relevant state.

## Claims

1. A method of monitoring the behavior of a plurality of battery blocks (b1, ..., bn) that are connected in series in a battery, for detecting a potentially anomalous state of one of the plurality of battery blocks (b1, ..., bn), the method comprising:
for each point in time of a plurality of points in time (t₀, t ₋₁, t ₋₂, ...), providing a voltage measurement (U_{b1}, ..., U_{bn}) of each of the plurality of battery blocks (b1, ..., bn) measured at the point in time;
for each point in time of the plurality of points in time (t₀, t ₋₁, t ₋₂, ...), and for each battery block of the plurality of battery blocks (b1, ..., bn), calculating a deviation value (ΔU_{b1}, ..., ΔU_{bn}; ΔQ_{b1}, ..., ΔQ_{bn}) of the battery block, wherein the deviation value is a voltage deviation of the voltage measurement of the battery block from an average (M) of the voltage measurements (U_{b1}, ..., U_{bn}) of the plurality of battery blocks (b1, ..., bn), or is a charge deviation of the battery block that corresponds to the voltage deviation;
for each battery block of the plurality of battery blocks (b1, ..., bn) and for a first time frame (T1), determining a mapping (10) of voltage values (U₁, ..., U_{z}) or current values (I₁, ..., I_{z}) to deviation values (ΔU₁, ..., ΔU_{z}), wherein to each voltage value of the voltage values (U₁, ..., U_{z}) or to each current value of the current values (I₁, ..., I_{z}), there is assigned an extreme value of those deviation values of the battery block that have been calculated for respective points in time at which a voltage measurement or a current measurement of the battery block has been measured that corresponds to the voltage value or, respectively, to the current value, said respective points in time belonging to the first time frame (T1); and
for each battery block of the plurality of battery blocks (b1, ..., bn), evaluating the determined mapping (10) to detect a potentially anomalous state of the battery block.

2. The method of claim 1, wherein said average (M) of the voltage measurements (U_{b1}, ..., U_{bn}) of the plurality of battery blocks (b1, ..., bn) is the median of the voltage measurements of the plurality of battery blocks.

3. The method of any one of the preceding claims, wherein said evaluating comprises evaluating the determined mapping (10) with respect to at least one reference deviation value (12; 14), wherein the at least one reference deviation value (12; 14) is at least one predetermined reference deviation value, or wherein the at least one reference deviation value is obtained based on the mappings for the other blocks of the plurality of battery blocks (b1, ..., bn), or wherein the at least one reference deviation value is obtained based on corresponding mappings of a corresponding battery block of corresponding batteries.

4. The method of any one of the preceding claims, wherein said evaluating comprises evaluating the determined mapping with respect to at least one reference mapping (40), wherein the at least one reference mapping is a predetermined reference mapping, or wherein the at least one reference mapping comprises the mappings for the other blocks of the plurality of battery blocks, or wherein the at least one reference mapping (40) is obtained based on corresponding mappings of a corresponding battery block of corresponding batteries (42).

5. The method of any one of the preceding claims, wherein the potentially anomalous state of the battery block is a potentially safety-relevant state and/or a state reflecting a manufacturing defect.

6. The method of any one of the preceding claims 1 to 5,
wherein the mapping (10) is a mapping of voltage values (U₁, ..., U_{z}) to deviation values (ΔU₁, ..., ΔU_{z}),
wherein the steps of determining a mapping (10) and evaluating the determined mapping (10) are repeated for at least one second time frame (T2),
wherein said evaluating comprises: detecting, in a predetermined upper voltage partial range of a voltage range that includes the voltage measurements of the battery block, a negative deviation (16) of the deviation values with respect to a first reference deviation value (14); and determining whether the negative deviation (16) increases over monitoring time.

7. The method of any one of the preceding claims 1 to 5,
wherein the mapping (10) is a mapping of voltage values (U₁, ..., U_{z}) to deviation values (ΔU₁, ..., ΔU_{z}),
wherein said evaluating comprises:
detecting, in a predetermined upper voltage partial range of a voltage range that includes the voltage measurements of the battery block, a positive deviation (22) of the deviation values with respect to a predetermined second reference deviation value, the positive deviation (22) overall increasing with increasing voltage values; and
detecting, in a predetermined lower voltage partial range of the voltage range that includes the voltage measurements of the battery block, a negative deviation (24) of the deviation values with respect to a predetermined third reference deviation value, the negative deviation (24) overall increasing with decreasing voltage values.

8. The method of any one of the preceding claims 1 to 5, wherein the mapping (10) is a mapping of voltage values (U₁, ..., U_{z}) to deviation values (ΔU₁, ..., ΔU_{z}), wherein the method includes: evaluating the determined mappings of each battery block of the plurality of battery blocks (b1, ..., bn) to determine whether at least one first mapping and at least one second mapping of the mappings show respective deviations from zero deviation, the deviations of the at least one first mapping being overall symmetric to the deviations of the at least one second mapping of the mappings with respect to a sign of the deviation values, and if this is the case, detecting a potentially anomalous state of the corresponding battery blocks.

9. The method of any one of the preceding claims 1 to 5,
wherein the mapping (10) is a mapping of voltage values (U₁, ..., U_{z}) to deviation values (ΔU₁, ..., ΔU_{z}),
wherein said evaluating comprises:
detecting, in a predetermined upper voltage partial range of a voltage range that includes the voltage measurements of the battery block, a negative deviation (26) of the deviation values with respect to a predetermined fourth reference deviation value the negative deviation overall increasing with increasing voltage values; and
detecting, in a predetermined lower voltage partial range of the voltage range that includes the voltage measurements of the battery block, a positive deviation (28) of the deviation values with respect to a predetermined fifth reference deviation value, the positive deviation overall increasing with decreasing voltage values.

10. The method of any one of the preceding claims 1 to 5,
wherein the mapping (10) is a mapping of voltage values (U₁, ..., U_{z}) to deviation values (ΔU₁, ..., ΔU_{z}),
wherein the steps of determining a mapping (10) and evaluating the determined mapping (10) are repeated for at least one second time frame (T2),
wherein said evaluating comprises: detecting, in a predetermined lower voltage partial range of a voltage range that includes the voltage measurements of the battery block, a negative deviation (32) of the deviation values with respect to a seventh reference deviation value; and determining whether the negative deviation increases over monitoring time.

11. The method of any one of the preceding claims 1 to 5,
wherein the mapping (10) is a mapping of voltage values (U₁, ..., U_{z}) to deviation values (ΔU₁, ..., ΔU_{z}),
wherein the method comprises:
scaling (46) and/or adjusting the determined mapping (10) based on a reference mapping (40), before the step of evaluating the mapping (10), wherein the reference mapping (40) is obtained based on corresponding mappings of a corresponding battery block of corresponding batteries (42),
wherein said evaluating comprises:
detecting, in a predetermined lower voltage partial range of the voltage range that includes the voltage measurements of the battery block, a positive deviation (44) of the deviation values with respect to a predetermined sixth reference deviation value, the positive deviation overall increasing with decreasing voltage values.

12. The method of any one of the preceding claims 1 to 5,
wherein the mapping (50) is a mapping of current values (I₁, ..., I_{z}) to deviation values (ΔU₁, ..., ΔU_{z}),,
wherein said evaluating comprises:
determining a zero current deviation value (66) that corresponds to the value of a linear function (64) at a current value of zero, the linear function (64) having a best fit to the mapping (50),
wherein when the absolute value of the zero current deviation value (66) exceeds a threshold value, a potentially anomalous state of the battery block is detected that is a potentially safety-relevant state.

13. A battery monitoring system (100), the system comprising means for carrying out the steps of the method of any one of claims 1 to 12.
